(19) Europäisches Patentamt
European Patent Office
Office européen des brevets

(11) **EP 2 961 012 A1**

(12) **EUROPEAN PATENT APPLICATION**

(43) Date of publication:
**30.12.2015 Bulletin 2015/53**

(51) Int Cl.:
*H01S 3/0941* (2006.01)   *H01S 3/115* (2006.01)
*H01S 3/00* (2006.01)   *B23K 26/08* (2014.01)
*B23K 26/06* (2014.01)   *H01S 3/08* (2006.01)
*H01S 3/094* (2006.01)   *H01S 3/102* (2006.01)
*H01S 3/16* (2006.01)   *H01S 3/23* (2006.01)
*H01S 3/10* (2006.01)

(21) Application number: **14382246.8**

(22) Date of filing: **26.06.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Light Speed Marker, S.L.
08720 Vilafranca del Penedes (ES)**

(72) Inventors:
• **Galán Valiente, Miguel
Barcelona (ES)**
• **Voces Sánchez, Felipe
Barcelona (ES)**

(74) Representative: **Grünecker Patent- und
Rechtsanwälte
PartG mbB
Leopoldstraße 4
80802 München (DE)**

(54) **Laser system for modifying objects**

(57)     A system for modifying a surface of an object, comprising a transport mechanism for transporting an object, a laser pulse generator (101) for generating a laser pulse having an energy between 200mJ and 400mJ by pumping an active medium, a spatial light modulator (102) being adapted to spatially modulate a laser pulse generated by the laser pulse generator and comprising an emitting surface that is adapted to emit a spatially modulated laser pulse, the spatial light modulator and the laser pulse generator being arranged to emit a spatially modulated laser pulse onto a surface of an object transported by the transport mechanism, wherein the laser pulse generator comprises a Q-switch and a control unit that is adapted to control the point in time the Q-switch is switched, depending on a transport property of the object; and a method for modifying the surface of an object. The laser is a Q-switched laser with laser emission in synchronisation with transportation of the objects (130) to be machined. The position of an object is monitored with a detector (240). The Q-switching times ($t_1$, $t_2$, $t_3$) are calculated in dependence of the constant transportation velocity and the detected positions of the objects (231,232,233,234).

FIG. 2a

EP 2 961 012 A1

Printed by Jouve, 75001 PARIS (FR)

FIG. 2b

## Description

The present invention relates to a system, especially a laser system, for modifying the surface of an object by means of laser pulses.

## Prior art

Systems for modifying the surface of an object, for example a can, are known in the art. For example, various printing technologies and press technologies are used to mark objects with, for example time stamps or the like. Further, laser systems including masks through which the laser pulse is emitted are known. However, these systems suffer from the fact that the actual image that is projected onto the object cannot be modified between two objects unless there is sufficient time, for example minutes or even hours, to exchange the masks.

Accordingly, such laser systems are not suitable for application in mass production of objects like cans or the like.

## Objective of the invention

Starting from the prior art, it is an object of the present invention to provide a system for modifying a surface of an object with a laser pulse that is applicable in mass production and, at the same time, can achieve a high variability with respect to the quality of the modified surface and the actual image provided on the modified surface.

## Solution

This problem is solved by the system for modifying a surface of an object according to independent claim 1 and the method for modifying a surface of an object according to claim 10. Advantageous embodiments of the invention are included in the dependent claims.

According to the invention, the system for modifying a surface of an object comprises a transport mechanism for transporting an object, a laser pulse generator for generating a laser pulse having an energy between 200mJ and 400mJ by pumping an active medium, a spatial light modulator being adapted to spatially modulate a laser pulse generated by the laser pulse generator and comprising an emitting surface that is adapted to emit a spatially modulated laser pulse, the spatial light modulator and the laser pulse generator being arranged to emit a spatially modulated laser pulse onto a surface of an object transported by the transport mechanism, wherein the laser pulse generator comprises a Q-switch and a control unit that is adapted to control the point in time the Q-switch is switched, depending on a transport property of the object. By providing a spatially modulated laser pulse with such a high energy that impinges on the surface of the object, the surface of the object is modified, which can be controlled by means of the spatial light modulator. The variable point in time the Q-switch is switched allows for applying the laser pulse generator in mass production, where laser pulses are to be emitted at specific points in time that are not necessarily reoccurring periodically.

In one embodiment, the system is characterized in that a pulse repetition frequency, corresponding to adjacent points in time the Q-switch is switched, can be adjusted between 0,1 Hz and 50Hz, depending on the transport property. Thereby, influence of transport properties, for example the actual position of the object and/or the transport velocity, can be compensated by adjusting the repetition frequency.

The laser pulse generator may comprise an active medium being a solid state rod and consisting of or comprising one of the following: Nd:YAG, Nd:YLF, Yb:YAG, Yb:YLF, Yb:CAF. These materials emit a laser pulse with different properties that can be used in order to fulfill specific requirements regarding the modification of the surface of the object.

In one further embodiment, the laser pulse generator comprises a plurality of laser diodes that are adapted to pump the active medium and are arranged such that a radiation plane of laser radiation emitted from the laser diodes and corresponding to the greatest emission angle is essentially parallel or oblique to a longitudinal axis of the active medium. Thereby, uniform pumping of the active medium can be achieved, which results in high-quality laser pulses being emitted and high laser pulse energy.

In an advantageous modification of this embodiment, a reflector is arranged between the active medium and the laser diodes and surrounding the active medium and comprising gap portions that are transparent for the radiation that can be emitted by the laser diodes, wherein the reflector is formed such that radiation that can be emitted from the laser diodes and can pass through the active medium via at least one of the gap portions can be reflected onto the active medium, wherein the reflector is arranged such that the reflector surrounds the active medium at a distance to the active medium and the reflector comprises a self-supporting cylinder consisting at least in part of a metal, e.g., copper. Thus, radiation emitted from the laser diodes and travelling through the active medium without being absorbed is reflected back into the active medium, thereby depositing more energy within the active medium and thereby increasing the energy of the generated laser pulses and/or decreasing the time needed for generating a laser pulse.

Further, the spatial light modulator may comprise a plurality of microlenses being arranged in a regular pattern and being adjustable by the control unit with respect to the orientation of the optical axis of each microlens and/or with respect to at least one refractive property of each microlens. Using these microlenses provides high flexibility with respect to the actual appearance of the modified region of the surface of the object.

In a modification of this embodiment, the control unit is adapted to control the plurality of microlenses depending on a predefined spatial modulation of the spatially modulated laser pulse. Thereby, control of the microlenses depends on the actual image or pattern that is to be generated by modifying the surface of the object.

In a further embodiment, the system is characterized in that it comprises a second active medium that is arranged in propagation direction of the laser pulse between the active medium and the spatial light modulator and is adapted to amplify a generated laser pulse passing through the second active medium. Thereby, even stronger laser pulses can be generated that propagate through the spatial light modulator.

Moreover, the spatial light modulator may be adapted to cause the spatially modified laser pulse to create predefined patterns comprising letters and/or numbers and/or a number of dots, wherein a spot density is between 100dots/cm$^2$ and 1000dots/cm$^2$ on a surface of a container that is to be modified. This embodiment of the invention provides high flexibility with respect to the patterns generated by modifying the surface of the object.

The method for modifying a surface of an object according to the invention comprises transporting an object and generating a laser pulse having an energy between 200mJ and 400mJ by pumping an active medium of a laser pulse generator and switching a Q-switch to generate the laser pulse, wherein the generated laser pulse passes a spatial light modulator that spatially modulates the laser pulse to generate a spatially modulated laser pulse that impinges on the transported object, wherein the point in time the Q-switch is switched is controlled depending on a transport property of the object. This method allows for modifying the surface of an object in order to, for example, generate a specific pattern in a very flexible manner and in a way that is applicable in mass production of objects like cans.

Further, the method may be characterized in that a pulse repetition frequency, corresponding to adjacent points in time the Q-switch is switched, is adjusted between 0,1Hz and 50Hz, depending on the transport property. With this embodiment, changes, for example in the transport velocity and/or position of the objects, can be compensated.

It may be provided that the laser pulse is a TEM00 mode laser pulse and has a pulse duration between 10ns and 30ns, preferably between 10ns and 15ns. Such short duration laser pulses result in modified regions on the surface of the objects with high accuracy.

Moreover, the generated laser pulse may extend between 3mm and 5mm in a plane perpendicular to the propagation direction of the generated laser pulse and/or the spatially modulated laser pulse extends between 8mm and 14mm, preferably 10 and 12 mm, most preferred 12mm in a plane perpendicular to the propagation direction of the spatially modulated laser pulse. Such a divergent beam allows for modifying the surface of the object in a sufficiently large region.

In one embodiment, the generated laser pulse and/or the spatially modulated laser pulse is a linear polarized laser pulse.

In a further embodiment, the laser pulse generated in the active medium passes a second active medium in which the generated laser pulse is amplified before the generated laser pulse impinges on the spatial light modulator. By further amplifying the laser pulse, even higher laser pulse energies can be achieved, which allows for modifying, for example, objects having a surface of aluminum or other metals.

In an advantageous modification of the invention, the generated laser pulse is modulated within the spatial light modulator by a plurality of regularly arranged microlenses that are controlled with respect to the orientation of the optical axis or the refractive properties of each microlens, depending on a predefined spatial modulation of the spatially modulated laser pulse. Using these microlenses within the spatial light modulator provides the ability to flexibly adjust the pattern generated by the spatially modulated laser pulse impinging on the object.

In addition, the method may be characterized in that the spatially modulated laser pulse modifies the surface of the object by creating predefined patterns comprising letters and/or numbers and/or a number of dots, wherein a spot density is between 100dots/cm$^2$ and 1000dots/cm$^2$. Thereby, images and/or numbers can be imprinted onto the surface of the object in order to, for example, add a minimum durability date on a can comprising a fluid.

Further, a laser pulse generator for generating laser pulses according to one embodiment of the invention comprises a pumpable, solid state active medium, a plurality of pumping laser diodes for pumping the active medium, that are arranged in a cylinder mantle in parallel to a longitudinal axis of the active medium, and a resonator comprising first and second optical systems, wherein the first optical system is arranged on one side of the active medium and is adapted to reflect back radiation emitted from the active medium into the active medium, and the second optical system is arranged on an opposite side of the active medium and is adapted to reflect back radiation emitted from the active medium into the active medium, and is characterized in that a main plane of the first optical system extends perpendicular to the longitudinal axis of the active medium and is placed inside the active medium. This allows for effectively compensating the thermal lens of the active medium and therefore results in a more accurately modulated TEM$_{00}$ mode of the laser pulse.

In one embodiment, the main plane is placed in a distance of at least L/10, or at least L/5, or at least L/4, or at least L/3 of the side of the active medium at which the first optical system is arranged, or in the center of the active medium, wherein L is the extent of the active medium in the longitudinal direction. By appropriately adjusting the first optical system in order to place the main plane, the requirements regarding compensation of the thermal lens can be fulfilled.

Further, the first optical system may comprise a telescope and a planar mirror. This arrangement of the first optical system is comparably simple, and, therefore, less failure prone.

According to a further development of this embodiment, the telescope comprises a convex lens and concave lens, the convex lens being arranged closer to the active medium as the concave lens. Thus, radiation reflected back into the active medium is focused by the convex lens before entering the active medium, thus compensating the thermal lens of the active medium.

The laser pulse generator may be characterized in that the second optical system comprises a parabolic mirror, or a spherical mirror, arranged and adapted to reflect back radiation emitted from the active medium into the active medium. This mirror can be used to further focus the radiation emitted from the active medium into the active medium.

Further, the laser pulse generator may comprise a Nd:YLF crystal rod or a Nd:YAG rod as active medium. Nd:YLF crystals result in laser pulses having higher energy, although the pulse duration is longer, whereas ND:YAG crystals result in shorter pulses having less energy.

Still further, in one embodiment, the laser pulse generator is characterized in that the total output power of the laser diodes is between 5000W and 6000W, preferably between 5200W to 5600W, most preferred 5400W. By choosing a corresponding total output power of the laser diodes, the resulting pulse power and the thermal stress applied to the active medium can be controlled. Moreover, the laser pulse generator may be adapted to generate pulses having a duration between 15ns and 30ns, preferably between 20ns and 25ns, the laser pulses having an energy of 150mJ.

Advantageously, the laser pulse generator comprises a variable Q-switch that is adapted to have an adjustable switch point, wherein the time between switch points, corresponding to successive laser pulses, can be varied. Thereby, the moment of the actual generation and transmission of the laser pulse can be adjusted, for example, depending on other conditions like actual temperature. This is especially advantageous when the laser pulse is to be applied on further objects in a time-dependent manner.

It might also be provided that the first optical system is adapted to reflect back radiation emitted by the active medium into the active medium such that a percentage of the surface of the active medium, onto which the reflected radiation falls, is illuminated by the reflected radiation, wherein the percentage is at least 95%, preferably at least 98%, most preferred more than 99%. Thereby, almost the complete active medium is illuminated by the reflected radiation leading to a higher number of photons being generated in the excited active medium by stimulated emission.

In one embodiment, the laser pulse generator is characterized in that the first optical system can be adjusted depending on the temperature of the active medium with respect to at least one optical property of the first optical system. Thereby, the optical characteristics of the first optical system can be adjusted to match, at different temperatures, the requirements for compensating the thermal lens of the active medium, which is temperature dependent.

A method for generating laser pulses is provided by using a laser pulse generator according to any of the preceding embodiments. By applying the laser system in a method for generating laser pulses, the above-described advantages can be used in generating $TEM_{00}$ modes.

In one embodiment, the method is characterized in that the time between switch points, corresponding to successive laser pulses, of the Q-switch is varied. By varying the time between the switch points, the actual emission of a laser pulse can be adjusted and, therefore, the laser pulses can be generated and applied to, for example, other objects at well-defined times, which may not be periodically but rather irregular.

Further, the duration of pumping phases during which the active medium may be pumped is adjusted in accordance with a pulse generation frequency. Thereby, the pumping periods are adapted in accordance with the pulse generation frequency in order to generate a high energy density within the active medium, before generating the laser pulse.

In one advantageous modification, the method is characterized in that at least one property of the first optical system is adjusted depending on the temperature of the active medium, wherein the location of the main plane of the first optical system within the active medium or the refractive power or the magnification of the first optical system is changed. Thus, the arrangement of the main plane of the first optical system can be shifted or the refractive power or the magnification can be adapted in order to maintain compensation of the thermal lens effect of the active medium even when the temperature within the active medium changes.

**Brief description of the drawings**

Figure 1: Schematic top view of a system according to one embodiment of the invention.

Figures 2A and 2B: Schematic depiction of a further embodiment of the invention and switching points of the Q-switch.

Figure 3: Schematic depiction of an arrangement of laser diodes according to one embodiment of the invention.

Figures 4A and 4B: Schematic depiction of a reflector according to one embodiment of the invention.

Figure 5: Schematic depiction of a method for modifying the surface of an object according to one embodiment of the invention.

Figure 6: A schematic depiction of a laser system according to one embodiment of the invention

Figure 7: A more detailed depiction of a laser system according to one embodiment of the invention

Figure 8a-8c: Modification of the position of the main plane according to one embodiment of the invention

Figure 9: Schematic depiction of a pumping and Q-switching procedure according to one embodiment of the invention.

Figure 10: Schematic depiction of the case according to one embodiment of the invention

**Detailed description**

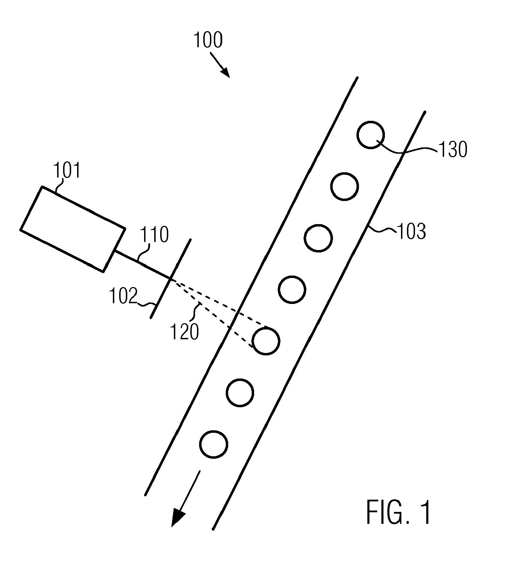

Figure 1 is a schematic top view of a system 100 according to one embodiment of the invention. The system 100 comprises a laser pulse generator 101 that is adapted to generate a laser pulse 110. This laser pulse may preferably carry an energy between 200mJ and 400mJ, although other energy values are also possible. Further, the energy of an emitted laser pulse 110 may be variable and/or adjustable by a control unit not shown in Figure 1.

Further, the system 100 comprises a transport mechanism 103 in which objects, for example, cans or the like, consisting of metal or comprising a surface consisting of or comprising metal, are transported. In the shown propagation direction (arrow), the containers 130 pass along the laser pulse generator 101. Between the laser pulse generator and a corresponding object 130 or the transport mechanism, respectively, a spatial light modulator 102 is placed. This spatial light modulator 102 is arranged such that a laser pulse 110 generated by the laser pulse generator 101 will impinge on the spatial light modulator 102 (SLM). By passing through the SLM 102, the laser pulse 110 is spatially modulated and, thereby, a spatially modified laser pulse 120 is generated, which propagates in almost the same direction the originally generated laser pulse 110 propagated, and impinges on the surface of one of the objects 130.

By impinging on the surface of the object 130, the spatially modified laser pulse 120 causes a modification of the surface of the object 130. For example, abrasion may take place or some carbon on the surface of the object 130 is charred. Further, it might be possible to modify a special material layer on the surface of the object 130 that is activated by being radiated with such a laser pulse. In any case, the surface of the object 130 is modified by the impinging spatially modified laser pulse 120.

Since the objects 130 are transported within the transport mechanism or by the transport mechanism 103, they have a specific transport velocity and, therefore, will pass the laser pulse generator 101 and the SLM 102 at a specific point in time. However, since points in time in which adjacent objects 130 pass the SLM 102 and the laser pulse generator 101 will not be perfectly periodical, a control unit is provided that is adapted to cause the laser pulse generator 101 to emit the generated laser pulse 110 depending on a specific signal received from the control unit. The control unit may emit this signal to the laser pulse generator 101 depending on specific properties of the transport of one or more of the objects in the transport mechanism 103. For example, the signal and emission of this signal may depend on the transport velocity or specific position of one or more of the objects, and/or the rotation velocity or orientation of the objects with respect to the laser pulse generator 101 and the SLM 102.

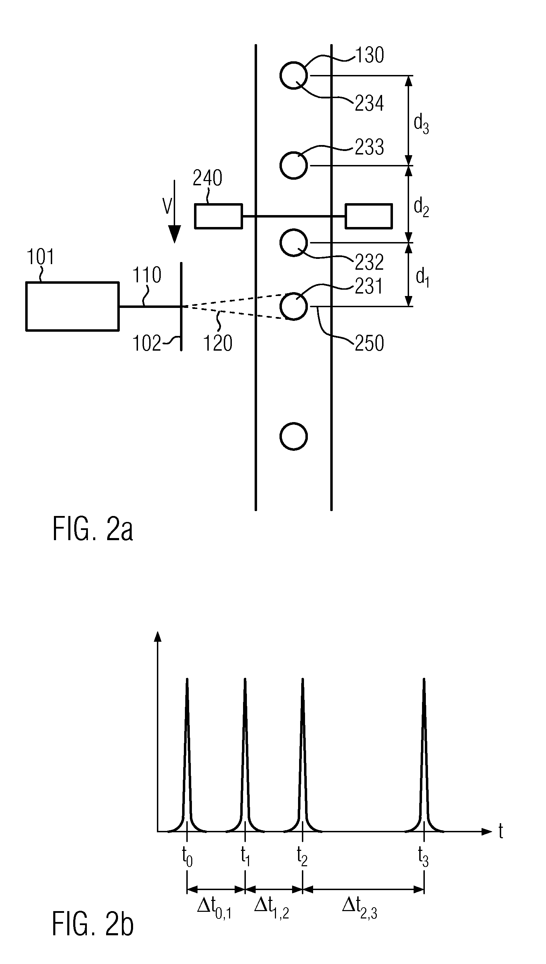

In this context, Figures 2A and 2B show one embodiment of the invention, in which the Q-switch within the laser pulse generator 101 is switched depending on the point in time at which the objects 130 pass a detector 240. This detector might be a light barrier or a camera, or other optical sensors. Further, ultrasonic sensors may be used to detect whether an object 130 passes the detector 240. Considering that the objects 130 may have a well-defined transport velocity V within the transport mechanism 103 , the control unit not shown can calculate, from the point in time at which the object 130 passes the detector 240, the time at which the object 130 will pass the SLM 102 and the laser pulse generator 101. Thus, it can be calculated at which point in time the laser pulse generator 101 has to emit a laser pulse 110 such that the spatially modified laser pulse 120 impinges on the correct region of the surface of the object 130.

To further support this, Figure 2B shows laser generations at times $t_0$, $t_1$, $t_2$, and $t_3$. These times are separated by time differences $\Delta t_{12}$ and $\Delta t_{23}$. The times $t_0$, $t_1$, $t_2$, and $t_3$, and the time differences correspond to the distance between the objects 231 and 232, 232 and 233, and 233 and 234 in the transport mechanism. Due to their distance from each other and the constant transport velocity that is equal for each of the objects 231 to 234, the objects 231 and 234 pass the detector 240 at different and not periodically identical times. Since the time from passing the detector 240 to arrive at the position 250 in which the object is to be radiated with the spatially modified laser pulse 120 is the same for each of the objects, and all of objects 231 to 234 move with the same velocity, the time difference between two laser pulses that are to be generated to radiate two adjacent objects solely depends on the distance d1, d2, and d3 between the objects 231 to 234, and the corresponding points in time at which the objects 231 to 234 pass the detector 240.

For example, starting with the object 231 passing the detector 240 at time T=0, the control unit will calculate that this object 231 will arrive at position 250 at time $t_0$. Thus, it will instruct the Q-switch within the laser pulse generator to switch at a corresponding time in order to emit the generated laser pulse and the laser pulse will impinge on the surface of the object 231. The second object 232 in this row will pass the detector 240 at a distance d1 from the first object 231. The corresponding time difference equals $d_1/V$. This time difference may be called $\Delta t_{0,1}$. Correspondingly, the control unit will instruct the Q-switch to switch at a time $t_1$, being separated from the time $t_0$ by $\Delta t_{0,1}$.

Correspondingly, the Q-switching times $t_2$ and $t_3$ for the objects 233 and 234 are calculated and these times are separated from $t_1$ by $\Delta t_{1,2}$ and from $t_2$ by $\Delta t_{2,3}$, respectively.

The embodiment described in Figures 2A and 2B is, of course, only one exemplary embodiment. Calculating the time in which the laser pulse is to be generated may not only depend on the transport velocity of the objects within the transport mechanism and their distance from each other, but further, for example, on the rotation velocity of each of the objects, or on other properties of the transport of the containers.

Further, the control unit may not only control the Q-switch, but also the pumping periods for pumping the active medium. Since the time needed for moving the objects 130 from the detector 240 to the point 250 is, in almost all practical cases, longer than the time needed to pump the active medium to allow emission of the laser pulse, the control unit may cause, for example, laser diodes to start pumping the active medium within the laser pulse generator a predefined time earlier than the time at which the object will pass position 250. As an example, pumping might start 500$\mu$s before the estimated or calculated time the Q-switch is switched.

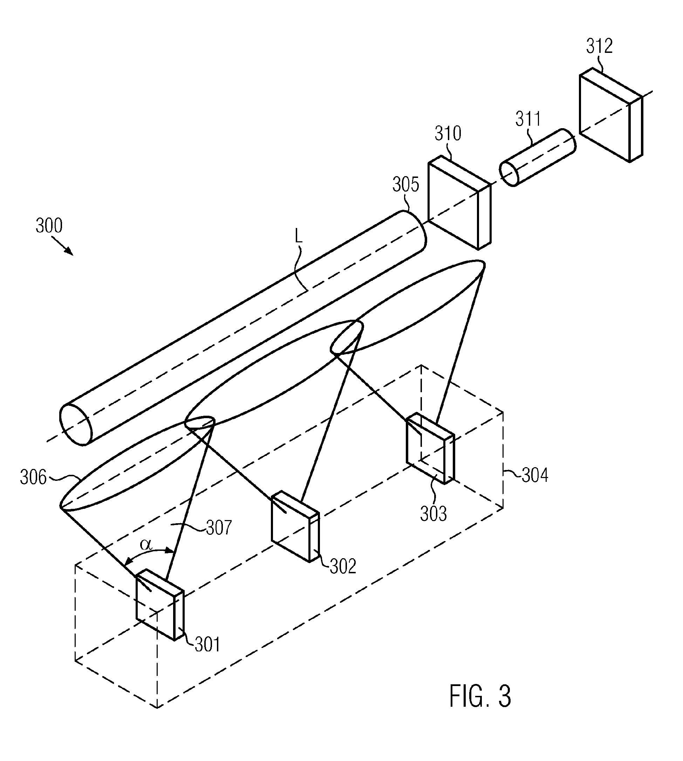

Figure 3 shows another embodiment of only the laser pulse generator 300. This laser pulse generator may comprise an active medium 305. This active medium preferably is, or comprises, a solid-state crystal rod being made of or including Nd:YAG or Nd:YLF or Yb:YAG or Yb:YLF or Yb:CAF, or other suitable materials. In order to generate a corresponding population inversion in order to cause the active medium to generate a laser pulse that may be coupled out by means of a Q-switch, a plurality of laser diodes 301 to 303 are arranged surrounding the active medium 305. These laser diodes may be provided by means of several blocks that surround the active medium in an equidistant arrangement. This means that each block has the same distance to the longitudinal axis L of the active medium 305, and further, the plurality of blocks 304 may be placed on an imaginary cylinder mantel being concentrical with the active medium 305. The blocks 304 may be arranged such that they have the same angular distance to each other. This means that, for example, when using five blocks, the angular distance of two adjacent blocks may be given by $2\pi/5$. In general, N blocks, therefore, may have the angular distance to each other given by $2\pi/N$.

In order to generate a high energy density within the active medium 305, the arrangement of laser diodes 301 to 303 may be such that their elliptical emission profile 306 incites on the active medium 305 such that the plane 307 that corresponds to the greatest emission angle $\alpha$ is in parallel to the longitudinal axis L of the active medium 305. It is noted that, when it is referred to the emission profile of the laser diodes in this application, this profile is defined by the amount of radiation having an intensity that is equal to 1/e or more of the maximum intensity in a section perpendicular to the optical axis of the laser diode (typically in the center of such a section). The intensity of 1/e of the maximum intensity may define the great and small half axis of the elliptical emission profile of the laser diode. For means of simplicity, it is assumed that the emission of radiation from the laser diode is limited to this region, which is define by a cone having a ground surface of elliptical shape with corresponding half axis and a peak point on the surface of the laser diode.

It is found that the arrangement of the laser emitting diodes is preferably such that radiation being emitted under the angle $\alpha$ travels in parallel to the longitudinal axis of the active medium 305. It can be advantageous to allow the radiation, being emitted by two adjacent laser diodes, to overlap before inciting on the boundary surface of the active medium 305, thereby ensuring that the complete active medium 305 receives energy from the laser diodes and can, therefore, be pumped (homogeneously). In order to achieve this, the distance of the laser emitting diodes with respect to the boundary surface of the active medium 305, and the distance between two adjacent laser diodes has to fulfill a specific relationship that depends on the angle $\alpha$ of the radiation emission profile of the first laser diode and the emission profile of the second laser diode (cones in Figure 3). It is assumed that the emission profile of both laser diodes is the same. If the laser diodes are placed at a distance d from each other, they have to be positioned at a distance h from the boundary surface of the active medium 305, such that the distance h is given by $h \geq \tan\left(\dfrac{\pi}{2} - \dfrac{x}{2}\right) \cdot \dfrac{d}{2}$. Thereby, the emission profile of the first laser diode and the second laser diode overlap on the surface of the active medium. If the laser diodes are arranged at a distance h fulfilling the equal relation of the equation above, the emission profile will overlap right on the boundary surface of the active medium 305. In case the distance h is longer, the emission profiles of the laser diodes will overlap before reaching the active medium 305. It can be advantageous to arrange the laser diodes at a distance h being slightly greater than the distance h that would fulfill the equal relation in the above equation, in order to take into account deviations due to thermal stress of the laser diodes while pumping, or to compensate thermal expansion of the active medium in a radial direction.

The embodiment described with reference to Figure 3 provides homogeneous pumping to the active medium 305, and therefore yields high energy density within the active medium, before generating the laser pulse. The laser pulse may be coupled out by a Q-switch that is not shown in this figure. However, a correspondingly generated and coupled out laser pulse may not have sufficient energy to modify the surface of an object. Therefore, in one embodiment, a further active medium 311 is arranged in parallel to the first active medium 305 outside of the emission region of the pumping laser diodes, at a distance to the first active medium 305. In the space between the first active medium and the second active medium 311, the Q-switch and all optics for emitting the laser pulse may be arranged (schematically shown by block 310) such that a laser pulse being emitted from the first active medium 305 incites on the second active medium 311. While the laser pulse propagates through the second active medium 311, the laser pulse is amplified. On the side of the surface the corresponding laser pulse leaves the second active medium 311, further optics 312 may be arranged in order to focus the laser pulse if necessary.

Therefore, the depiction in Figure 3 may be understand to work without the second active medium 311 or to be provided in combination with the second active medium 311.

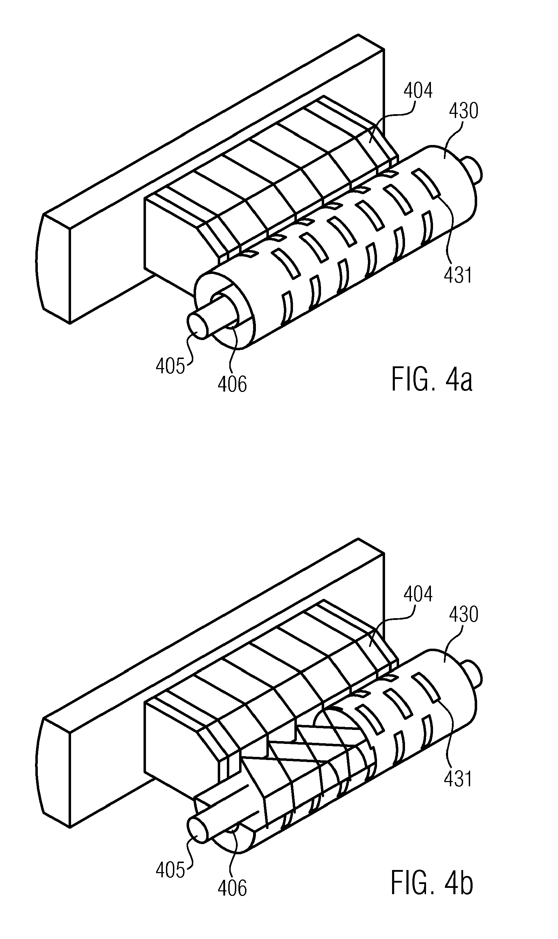

Since it is necessary to pump the first active medium 305 at high energies, in order to achieve this, a reflector may be provided that may also act as a cooling device for the active medium. Figures 4A and 4B show a corresponding reflector.

Typically, a quartz cylinder, being coated with for example a gold coating, is used for the reflector. Such coatings tend to detach from the quartz cylinder in particular under heavy thermal load. The coating is mechanically too weak to be self supporting and is supported by the quartz cylinder. In order to enhance manufacturing processes and reliability, a self-supported cylinder of a radiation reflecting metal, such as copper, can be used. Figure 4A shows a corresponding arrangement of the reflector 430 being arranged around the active medium 405. This reflector can be arranged such that the advantageous effects of a correspondingly arranged system of laser diodes as described above can be provided, although using a corresponding reflector being made of a self-supported metal cylinder, can be advantageous in any way. In view of Figure 4A, the reflector has a cylindrical shape, as has the active medium 405. Further, the reflector 430 is placed at a distance from the active medium 405. In the space between the active medium 405 and the reflector 430, a cooling agent such as water can be inserted and/or circulated. However, as the self-supported reflector 430 is made of metal, which preferably is a very good heat conductor (like iron, copper, gold, or silver), a cooling agent being inserted in the space 406 between the reflector 430 and the active medium can be omitted in case the heat which is transferred from the active medium 405 to the reflector 430 is transported out of the system by efficiently cooling the reflector 430. This yields a further miniaturization of a corresponding laser system and provides an additional advantage in view of reflecting the laser radiation being emitted from laser diodes in order to pump the active medium, since this radiation will no longer have to pass through the cooling agent which would lead to an amount of energy being absorbed in the cooling agent.

As can be seen in Figure 4B, the reflector 430 comprises gap portions 431. These gap portions 431 are arranged such that radiation being emitted from laser diodes that are arranged in block 404 can be transmitted through the reflector onto the active medium 405 in order to pump said active medium. As the reflector 430 can be manufactured for example with the help of milling and/or cutting and/or drilling processes, these portions 431 can be placed very precisely in order to allow a maximum amount of radiation to be transmitted through the portions 431 from the laser diodes in block 404. In order to further stabilize the active medium 405 and the reflector 430, it can be advantageous to provide a quartz cylinder that is placed between the active medium 405 and the reflector 430 and is joined to the reflector 430. Further, it can be advantageous to join the quartz cylinder to the active medium. In view of this, and in case the active medium has a cylindrical shape, it is preferred that the reflector 430 is arranged concentrically around the active medium with respect to the longitudinal axis of the active medium. In case a quartz cylinder is used, the same holds for this quartz cylinder.

The reflector may be made of copper, which has good heat conductivity and good reflectivity in the infrared radiation region and has good manufacturability. The thickness of the wall of the reflector may be in the range of 0.5mm to 2mm, such as between 0.75mm and 1.25mm.

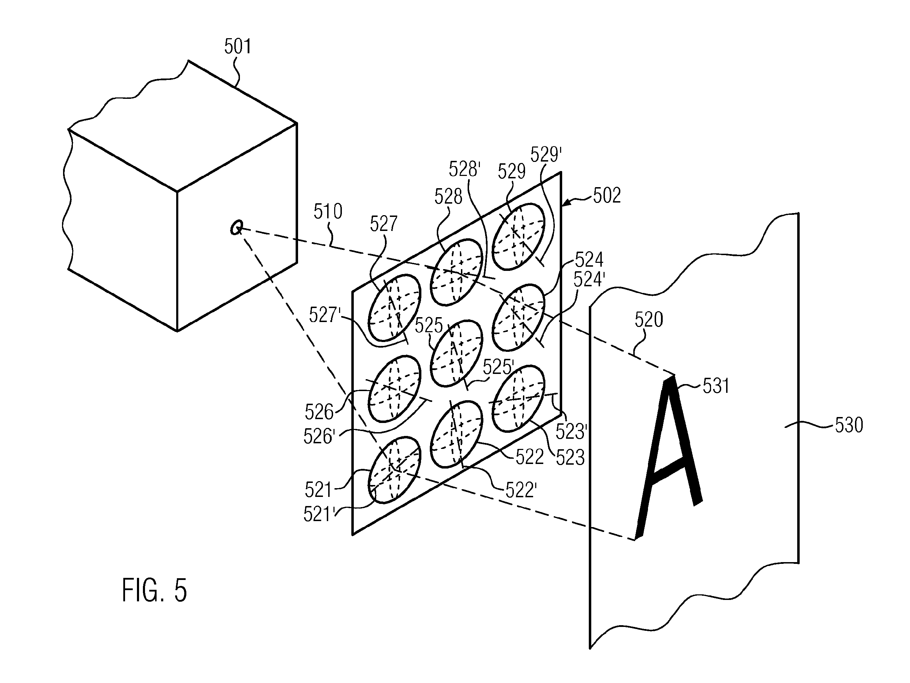

Figure 5 shows a further embodiment of the invention. This is a more detailed depiction of the arrangement described in Figures 1 and 2. The laser pulse generator 501 may be one of the laser pulse generators described with reference to Figure 3. From this laser pulse generator 501, a laser pulse 510 is emitted that propagates in the direction of the spatial light modulator 502. When leaving the laser pulse generator 501, the laser pulse may have a diameter between 3 and 5mm.

The spatial light modulator 502 may comprise a plurality of microlenses 521 to 529. The number of microlenses is, of course, not limited to 9 microlenses as shown here. The SLM 502 may comprise several ten or several hundred, or even several thousand microlenses. These microlenses are connected directly or indirectly to the control unit that can control the properties of the microlenses 521 to 529. These properties are the orientation of the optical axis 521' to 529' of each of the microlenses and/or their refractive properties, for example the refractive index. It is preferred that each of the microlenses 521 to 529 may be controlled by the control unit independently of each of the other microlenses. Thereby, the inciting laser pulse 510 is refracted by each microlens it incites on, thereby emitting a laser pulse part. Thus, the spatially modulated laser pulse 520 is made up of each laser pulse part emitted from the microlenses 521 to 529. Since the optical properties of each of the microlenses may be controlled independently, the spatially modulated laser pulse is, in almost every case, no longer a $TEM_{00}$ mode. Indeed, due to interference effects of the emitted laser pulse parts from each of the microlenses, the spatially modulated laser pulse 520 will create an image 531 when inciting on a surface of an object 530. Since this image 531 solely depends on the interference of each of the laser pulse parts emitted from the microlenses, it is possible to control, by the control unit, the optical properties of the microlenses such that a specific image 531 can be created. This image may comprise letters or specific patterns or dots. Depending on the number of microlenses and the degree of adjustability of their optical properties, it is possible to achieve high resolutions for the image 531. As an example, the image may comprise several ten, several hundred, or even several thousand dots/cm$^2$. In a preferred embodiment, the spatially modulated laser pulse impinging on the surface of the object 530 has a maximum extension between 8mm and 14mm when inciting on the surface of the object 530. This, of course, depends on the distance between the SLM 502 and the surface of the object 530. In a preferred embodiment, the dot density generated on the surface of the object 530 due to manipulation of the spatially modulated laser pulse 520 impinging the surface 530 is between 100 dots/cm$^2$ and 1000 dots/cm$^2$. Thereby, even complex images like QR codes or others can be imprinted on the surface of the object 530.

It is noted that even though this yields an image of very high quality and dot density, the described method and system do not suffer from problems like relative movement of the surface of the object 530 with respect to the laser pulse, since the laser pulse only has a duration between 5ns and 30ns, preferably 10ns and 15ns. During this time, the movement of the surface of the object 530 with respect to the impinging laser pulse can indeed be completely neglected without having any influence on the quality of the imprinted image. This provides significant advantages over commonly used printing technologies that use, for example, printing heads that print images onto containers or objects by means of ink.

In order to achieve such high resolutions of the modified region of the objects, it is necessary to generate the laser pulses at almost same quality with respect to their initial spatial modulation even for long term use of the laser system. This requires reduction of thermal effects due to the long time the active medium is excited by pumping it. Such long term pumping (several thousand pumping cycles for example) may heat up the active medium to such an extend, that the spatial modulation

of the $TEM_{00}$ mode is distorted.

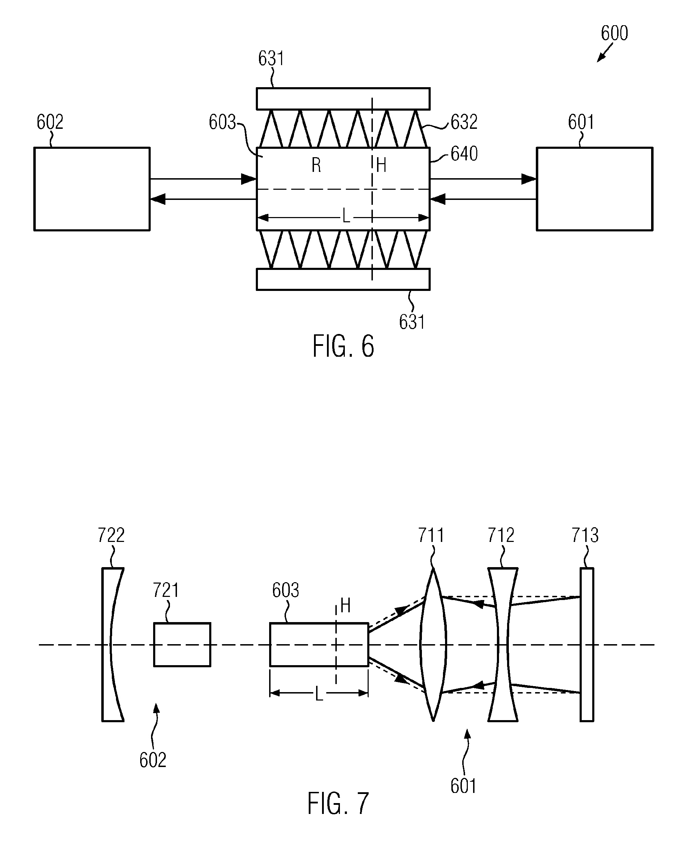

In order to compensate this, Figure 6 shows an exemplary schematic depiction of a laser system 600 that might be included in a laser pulse generator according to one embodiment of the invention. The laser system 600 comprises an active medium 603 that is placed between a resonator comprising two optical systems, a first optical system 601 and a second optical system 602. As commonly known in the art, at least one of the optical systems will be adapted to transmit a generated laser beam out of the system. This can be achieved by for example Q-switching a Pockels cell in one of the optical systems. Utilizing Pockels cells and Q-switches is well known in the art and will not be explained in further detail here. It is preferred that the active medium is adapted to emit laser pulses ($TEM_{00}$-modes) at energies around 250mJ, preferably between 200mJ-400mJ. The pulse duration should be between 10-30ns, preferably 10-15ns.

Further, the laser system 600 may comprise one or more laser diodes or laser diode arrays 631 for pumping 632 the active medium. These laser diodes may be arranged in a cylinder mantel surrounding the active medium 603 and being in parallel to a longitudinal axis R of the active medium, and have a total pumping power of 5000W-6000W, preferably 5200W-5600W, most preferred 5400W. The optical systems 601 and 602 of the resonator are placed at both sides of the active medium 603 in extension of the longitudinal axis R. The optical properties of the first optical system 601 are such that the main plane H of the optical system 601 extends perpendicular to the longitudinal axis of the active medium and is placed inside the active medium. The position of the main plane H with respect to an optical system that comprises two lenses having focal lengths $f_1$ and $f_2$ is

given by $\overline{HH_1} = \dfrac{f_1 d}{d - f_1 - f_2}$ , wherein d is the distance between the lenses and $H_1$ being the main plane of the lens being arranged closer to the active medium.

Such lenses f1 and f2 are respectively a positive and a negative lens and satisfy the condition of being arranged as a Galilean telescope, that is, the distance d between the lenses corresponds to d=f1+f2 . The actual distance between the lenses shall be written henceforth as d + δ wherein δ is known as the defocusing of the telescope. The focal length of the first lens can be, for example, $f_1$ =50-200 mm, preferably 75-125 mm, most preferred 100 mm, whereas the focal length of the second lens may be $f_2$=30-100 mm, preferably 40-80 mm, most preferred 50 mm. In such an arrangement, the position of the main plane H according to the above equation can be written as $HH = \overline{HH_1} = \dfrac{f_1 d}{\delta}$. As can be seen from this equation, the defocusing magnitude δ allows for accurately tuning the position of the main plane.

By placing the main plane H like this within the active medium, influence of the thermal lens of the active medium 603, which is an inevitable effect due to heating of the active medium 603 through pumping, can be efficiently compensated for. In order to achieve this, the main plane H may be placed within the active medium, having the length L, for example at a distance of LI/10 or L/5, or L/4, or L/3, from the side of the active medium which is closer to the first optical system. The defocusing distance $\delta$ may be tuned depending on the thermal lens. The defocusing distance may have a value between 1 - 10mm. In the exemplary embodiment shown in Figure 6, for example, the main plane H is placed at a distance of approximately L/3 from the side 640, at which the optical system is arranged. In a preferred embodiment, the main plane is arranged in the center of the active medium.

Figure 7 shows a more detailed view of the optical systems and the active medium 603. For simplicity's sake only, the laser diodes shown in Figure 1 are omitted here. As can be seen in Figure 7, the first optical system 601 comprises a convex lens, a concave lens, and a planar mirror. The convex lens 711 is placed closer to the active medium 603 than the concave lens 712. Likewise, the concave lens 712 is placed closer to the active medium 603 than the planar mirror 713. Thereby, radiation being emitted from the active medium 603 while being pumped travels through the convex lens 711 where it is focused. It then travels through the concave lens 712 where it is defocused and, finally, reaches the mirror 713, where it is reflected back into the concave lens 712 and the convex lens 711 which focuses the radiation back into the active medium 603. Due to the main plane H lying within the active medium 603, the thermal lens caused by thermal stress of the active medium 603 while being pumped is sufficiently compensated for, which results in an almost perfectly modulated $TEM_{00}$ mode, when Q-switching the system in order to generate the laser pulse, since deviations from the $TEM_{00}$ are caused to a high extent by the influence of the thermal lens of the active medium, which is difficult to control.

The second optical system 602 in this embodiment comprises a spherical or parabolic mirror 722 placed at a distance from the other side of the active medium 603 and means 721 for switching the resonator. Means 721 may comprise a Pockels cell as well as $\lambda/4$ plate. The mirror 722 may also be replaced by another optical system comprising a concave lens, being arranged closer to the active medium than a further convex lens and the parabolic mirror.

The active medium 603 may comprise or may consist of an Nd:YAG crystal rod or, preferably, an Nd:YLF crystal rod. The advantage of Nd:YLF crystal rods as an active medium is its long fluorescence lifetime compared to Nd:YAG lasers. Although this results in an even higher energy density within the active medium 603, the thermal lens caused by the accordingly high thermal stress in the active medium is sufficiently compensated for by the optical system 601, thereby resulting in $TEM_{00}$ laser pulse modes of the Nd:YLF crystal rod having a higher beam quality. Likewise, compared to Nd:YAG crystals, Nd:YLF crystals provide higher pulse energies. Thus, the laser system provided here can be used, for example, to imprint special marks or even dots onto a given surface.

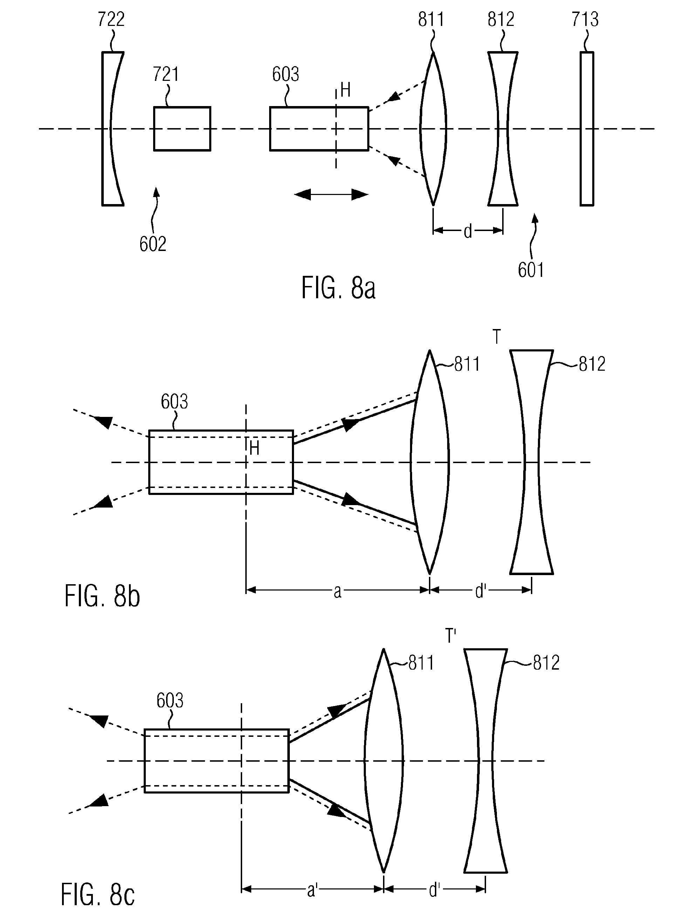

The effect of the thermal lens is strongly temperature dependent. In order to compensate for this, the embodiment shown in Figures 8a-8c allows for modifying the optical characteristics of the first optical system 601 in accordance with a rise or fall in temperature of the active medium 603.

Figure 8a shows the principle arrangement in which the position of the main plane H can be changed within the active medium by, for example, changing the distance d between the positive lens 811 and the negative lens 812. Since by changing the distance of the positive lens and concave lens, the actual focal length of the optical system is changed, the degree of focusing or defocusing of radiation emitted from the active medium 603 and traveling through the first optical system 601 can be influenced. In fact, the distance between the main plane H and the main plane $H_1$ of the convex lens is given by

$$\overline{HH_1} = \frac{f_1 d}{d - f_1 - f_2} \text{ , wherein } f_1 \text{ is the front vertex focal}$$

length of the concave lens and $f_2$ is the front vertex focal length of the positive lens and d is the distance between the convex and the negative lens.

By manipulating the distance between the lenses, for example by moving the negative or the positive lens or both, the position of the main plane H can be altered and the resulting focal length of the optical system can be manipulated. Thus, as shown in Figures 8b and 8c, it is possible to achieve refocusing of radiation, emitted by the active medium, back into the active medium after it passed through the first optical system, such that preferably the whole active medium is illuminated by the reflected radiation. This yields more stimulated relaxation of the electrons and therefore will increase the number of photons generated in the active medium, irrespective of a rise in temperature. Since, when temperature rises within the active medium 603, the defocusing effect of the thermal lens of the active medium 603 increases as well, it is preferred that with rising temperature the focal length of the first optical system is reduced. This will result in the first optical system focusing the radiation back into the active medium much stronger and, thereby, the increasing effect of the thermal lens at rising temperature is compensated for. Still further, providing the optical system in an embodiment such that the optical characteristics with respect to the position of the main plane and the focal length of the system can be manipulated, it is also possible to influence the percentage of the surface of the active medium onto which the reflective radiation falls. For example, with such an arrangement it is possible to illuminate 95 or even more, for example 98 or even 99% or more of the surface of the active medium 603, thereby ensuring that, while the radiation travels through the active medium, stimulated emission is achieved through preferably the complete extension of the active medium perpendicular to its longitudinal axis.

Thus, it is not only possible to ensure compensation of the thermal lens effect of a heated active medium, but also to adjust the percentage of the surface of the active medium that is illuminated with the radiation reflected back into the active medium, thereby influencing the degree of stimulated emission of further photons during the pumping procedure.

It is further noted that manipulating the distance between the lenses of the first optical system is not the only opportunity to change the position of the main plane and the focal length of the first optical system. Indeed, by changing the focal lengths of the lenses or by changing the refractive power of the first optical system or its magnification, the position of the main plan and/or the focal length or the refractive power can respectively be changed in order to compensate for the thermal lens effect of the active medium.

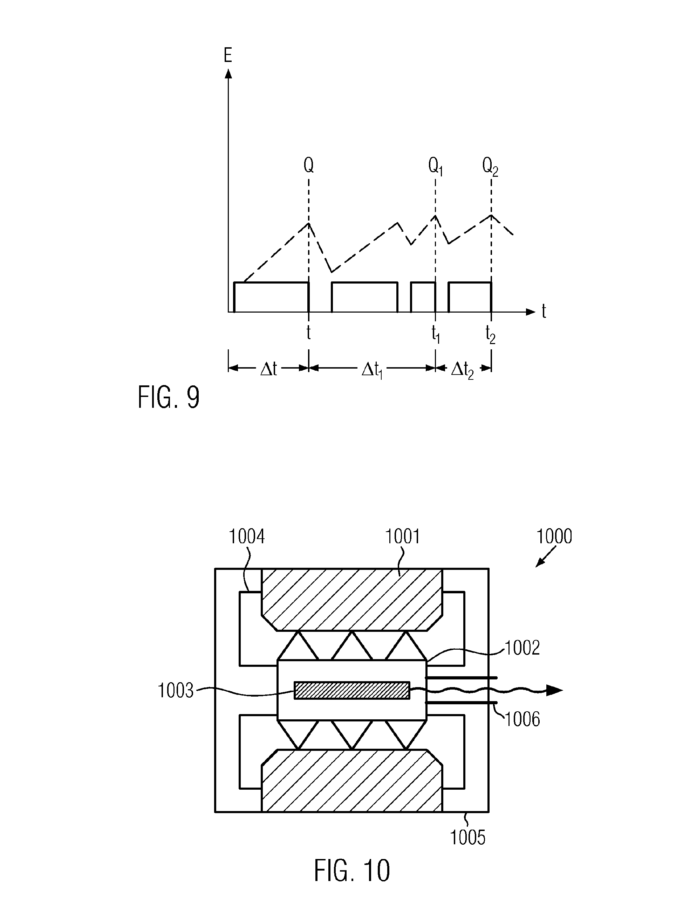

Figure 9 shows a further embodiment that is correlated with the actual generation of the laser pulse. In Figure 9, the pumping periods are shown with respect to the time. The pumping diodes are provided to pump the system within repeated pumping periods. Thereby, the amount of energy due to excitation of electrons within the active medium grows. Once the pumping ends, the excited electrons relax into the ground state, depending on the lifetime of the excited state The Q-switch is provided in order to make the laser system emit a laser pulse which is indicated in Figure 9 by points Q, Q1, and Q2, and the corresponding times t, $t_1$, and $t_2$. Since it is preferred that the energy density (i.e. number of photons) in the active medium is as high as possible before generating the laser pulse (i.e. Q-switching the system), the pumping periods may be altered depending on the times at which the Q-switch is to be switched. Further, the times t, t1, and t2 may be variable such that, in one exemplary case, the time between a first Q-switching and a second Q-switching, for example Q and Q1, takes place within the time interval $\Delta t_1$ equaling for example 300ms. On the other hand, a further Q-switching Q2 may take place after a time $\Delta t_2$ after the Q-switching Q1. In case $\Delta t_1$ and $\Delta t_2$ are not equal, the time that is available for pumping the active medium for the Q-switching Q2 is shorter than that for Q1. In order to nevertheless achieve energy density within the active medium before Q-switching at time $t_2$ that is almost equal to the energy density at $t_1$, the time interval for each pumping period may be altered and, likewise, the time between two adjacent pumping periods may be shorter in order to reduce energy loss within the active medium through relaxation of electrons into the ground state. Thereby, it can be ensured that each of the generated laser pulses have an energy of at least 150mJ, preferably between 200mJ and 400mJ.

This is advantageous for application of the laser system when printing or marking objects that are conveyed to the laser system. For example, one might consider metal containers like cans or tins that are to be marked with a symbol or a simple dot by the laser system. Although these cans may be transported at high accuracy having a distance of for example 5 cm from each other, even slight deviations from these distances will result in a different time at which the corresponding container is in front of the laser system to be marked. In order to ensure marking of the container at the correct position, the Q-switching of the laser system may be performed depending on a specific timing signal which indicates that the container is in the correct position for marking, as was described in the above embodiments of the invention. Thus, the times between two laser pulses emitted by the laser system can be varied within a time span. By providing the laser system with a variable Q-switch and correspondingly varied pumping periods, correct marking of each and every container can be ensured.

It is noted that, in order to achieve a corresponding marking of objects as described above, pumping energies of about 5400W are required. Nevertheless, in order to generate laser pulses having high energy, it is, in any case, preferred that the total of the power of the laser diodes is between 5000 and 6000W. When it comes to marking of containers, the total output power of the laser diodes may be preferably between 5200 and 5600W and may preferably be 5400W. Thus, by using an Nd:YLF crystal rod as active medium, laser pulses having a duration of 10-15ns at $1.053\mu m$ or $1.047\mu m$ can be generated having an energy of about 250mJ. Due to the above-described arrangement of the laser system, the generated $TEM_{00}$ mode of the laser pulse has a high beam quality and can, therefore, be efficiently used to locally transform matter by laser induced chemical or physical reactions.

Applying high energy laser systems in facilities for producing products might be difficult due to the high amount of energy transported in the laser pulses and the amount of energy that is dissipated from the system into the environment. This electromagnetic radiation may have an influence on other electronic system and may, therefore, cause problems that could even lead to a loss of quality with respect to the products.

Therefore, a cover or casing may be provided in which the laser pulse generator is included. According to the embodiment of the invention shown in Fig. 10, the complete laser pulse generator 1000 is provided within an electromagnetically almost completely sealed box 1005, wherein the laser system comprises an active medium 1003, a case 1002 that surrounds the active medium 1003, and may be provided with a laterally surrounding reflector, and further laser diodes being arranged in blocks 1001 for pumping the active medium 1003, as were described, for example, in Fig. 3. Preferably, the box 1005 only comprises one opening 1006 through which the radiation emitted from the active medium can be emitted. Such enclosure of components of the laser system prevents unintended emission of electromagnetic radiation. Further, according to one embodiment, the length of current carrying conduits, like cables, is reduced to the minimum length wherein, preferably, the whole conduit is placed within the box 1005. Preferably, only one conduit connection is provided that connects the laser system 1000 with an energy supply. Such a casing of a laser system renders the laser system suitable for application in production facilities, as potentially dangerous radiation is no longer emitted from the device 1000.

In order to further reduce the amount of electromagnetic radiation that is emitted, there can be provided a channel, from the opening 1006, to the active medium 1003 that is on a boundary surface sealed against transmission of electromagnetic radiation other than that emitted from the active medium.

A supply of cooling agent may be provided outside of the laser system 1000.

Optionally, all electronics that operate in a pulsed mode for driving the laser diodes are contained within the box 1005. A power supply to the box 1005 may be a DC or an AC power supply (at e.g. 50 or 60 Hz), which, lower, does not provide a pulsed mode for driving the laser diodes.

**Claims**

1. System for modifying a surface of an object, comprising a transport mechanism for transporting an object, a laser pulse generator for generating a laser pulse having an energy between 200mJ and 400mJ by pumping an active medium, a spatial light modulator being adapted to spatially modulate a laser pulse generated by the laser pulse generator and comprising an emitting surface that is adapted to emit a spatially modulated laser pulse, the spatial light modulator and the laser pulse generator being arranged to emit a spatially modulated laser pulse onto a surface of an object transported by the transport mechanism, wherein the laser pulse generator comprises a Q-switch and a control unit that is adapted to control the point in time the Q-switch is switched, depending on a transport property of the object.

2. System according to claim 1, **characterized in that** a pulse repetition frequency, corresponding to adjacent points in time the Q-switch is switched, can be adjusted between 0,1 Hz and 50Hz, depending on the transport property.

3. System according to claim 1 or 2, **characterized in that** the laser pulse generator comprises an active medium being a solid state rod and consisting of or comprising one of the following: Nd:YAG, Nd:YLF, Yb:YAG, Yb:YLF, Yb:CAF.

4. System according to any of claims 1 to 3, **characterized in that** the laser pulse generator comprises a plurality of laser diodes that are adapted to pump the active medium and are arranged such that a radiation plane of laser radiation emitted from the laser diodes and corresponding to the greatest emission angle $\alpha$ is essentially parallel or oblique to a longitudinal axis of the active medium.

5. System according to claim 4, **characterized in that** a reflector is arranged between the active medium and the laser diodes and surrounding the active medium and comprising gap portions that are transparent for the radiation that can be emitted by the laser diodes, wherein the reflector is formed such that radiation that can be emitted from the laser diodes and can pass through the active medium via at least one of the gap portions can be reflected onto the active medium, wherein the reflector is arranged such that the reflector surrounds the active medium at a distance to the active medium and the reflector comprises a self-supporting cylinder consisting at least in part of a metal, e.g. copper.

6. System according to any of claims 1 to 5, **characterized in that** the spatial light modulator comprises a plurality of microlenses being arranged in a regular pattern and being adjustable by the control unit with respect to the orientation of the optical axis of each microlens and/or with respect to at least one refractive property of each microlens.

7. System according to claim 6, **characterized in that** the control unit is adapted to control the plurality of microlenses depending on a predefined spatial modulation of the spatially modulated laser pulse.

8. System according to any of claims 1 to 7, **characterized in that** the system comprises a second active medium that is arranged in propagation direction of the laser pulse between the active medium and the spatial light modulator and is adapted to amplify a generated laser pulse passing through the second active medium.

9. System according to any of claims 1 to 8, **characterized in that** the spatial light modulator is adapted to cause the spatially modified laser pulse to create predefined patterns comprising letters and/or numbers and/or a number of dots, wherein a spot density is between 100dots/cm$^2$ and 1000dots/cm$^2$ on a surface of a container that is to be modified.

10. Method for modifying a surface of an object, the method comprising transporting an object and generating a laser pulse having an energy between 200mJ and 400mJ by pumping an active medium of a laser pulse generator and switching a Q-switch to generate the laser pulse, wherein the generated laser pulse passes a spatial light modulator that spatially modulates the laser pulse to generate a spatially modulated laser pulse that impinges on the transported object, wherein the point in time the Q-switch is switched is controlled depending on a transport property of the object.

**11.** Method according to claim 10, **characterized in that** a pulse repetition frequency, corresponding to adjacent points in time the Q-switch is switched, is adjusted between 0,1 Hz and 50Hz, depending on the transport property.

**12.** Method according to claim 10 or 11, **characterized in that** the laser pulse is am TEMoo mode laser pulse and has a pulse duration between 10ns and 30ns, preferably between 10 and 15ns.

**13.** Method according to any of claims 10 to 12, **characterized in that** the generated laser pulse extends between 3mm and 5mm in a plane perpendicular to the propagation direction of the generated laser pulse and/or the spatially modulated laser pulse extends between 8mm and 14mm, preferably 10 and 12 mm, most preferred 12mm in a plane perpendicular to the propagation direction of the spatially modulated laser pulse.

**14.** Method according to any of claims 10 to 13, **characterized in that** the generated laser pulse and/or the spatially modulated laser pulse is a linear polarized laser pulse.

**15.** Method according to any of claims 10 to 14, **characterized in that** the laser pulse generated in the active medium passes a second active medium in which the generated laser pulse is amplified before the generated laser pulse impinges on the spatial light modulator.

**16.** Method according to any of claims 10 to 15, **characterized in that** the generated laser pulse is modulated within the spatial light modulator by a plurality of regularly arranged microlenses that are controlled with respect to the orientation of the optical axis or the refractive properties of each microlens, depending on a predefined spatial modulation of the spatially modulated laser pulse.

**17.** Method according to any of claims 10 to 16, **characterized in that** the spatially modulated laser pulse modifies the surface of the object by creating predefined patterns comprising letters and/or numbers and/or a number of dots, wherein a spot density is between 100dots/$cm^2$ and 1000dots/$cm^2$.

FIG. 1

FIG. 2a

FIG. 2b

FIG. 3

FIG. 4a

FIG. 4b

FIG. 5

FIG. 6

FIG. 7

FIG. 8a

FIG. 8b

FIG. 8c

FIG. 9

FIG. 10

**Europäisches Patentamt**
**European Patent Office**
**Office européen des brevets**

## EUROPEAN SEARCH REPORT

Application Number

EP 14 38 2246

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/052101 A1 (GU JIANHUI [SG] ET AL) 20 March 2003 (2003-03-20) | 1-3, 10-15 | INV. H01S3/0941 H01S3/115 |
| Y | * paragraphs [0025] - [0056]; figure 9 * | 1-17 | H01S3/00 |
| | ----- | | B23K26/08 |
| X | EP 0 339 888 A1 (AMCHEM CO LTD [GB]) 2 November 1989 (1989-11-02) | 1-3,10, 11 | B23K26/06 |
| Y | * column 2, line 27 - column 5, line 27; figures 1,2 * | 4,5 | ADD. H01S3/08 |
| Y | US 6 423 935 B1 (HACKEL LLOYD A [US] ET AL) 23 July 2002 (2002-07-23) * column 4, line 21 - column 8, line 9; figures 1,2 * | 1-17 | H01S3/094 H01S3/102 H01S3/16 H01S3/23 H01S3/10 |
| Y | DE 195 18 177 A1 (FRAUNHOFER GES FORSCHUNG [DE]) 21 November 1996 (1996-11-21) * column 5, line 9 - column 7, line 29; figures 1,3-6 * | 3-5 | |
| | ----- | | |

TECHNICAL FIELDS SEARCHED (IPC)

H01S
B23K

The present search report has been drawn up for all claims

| Place of search | Date of completion of the search | Examiner |
|---|---|---|
| Munich | 12 November 2014 | Laenen, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 14 38 2246

This annex lists the patent family members relating to the patent documents cited in the above-mentioned European search report.
The members are as contained in the European Patent Office EDP file on
The European Patent Office is in no way liable for these particulars which are merely given for the purpose of information.

12-11-2014

| Patent document cited in search report | | Publication date | Patent family member(s) | | Publication date |
|---|---|---|---|---|---|
| US 2003052101 | A1 | 20-03-2003 | NONE | | |
| EP 0339888 | A1 | 02-11-1989 | CA | 1322780 C | 05-10-1993 |
| | | | DE | 68905647 D1 | 06-05-1993 |
| | | | DE | 68905647 T2 | 08-07-1993 |
| | | | EP | 0339888 A1 | 02-11-1989 |
| | | | US | 4952789 A | 28-08-1990 |
| US 6423935 | B1 | 23-07-2002 | AU | 4144801 A | 27-08-2001 |
| | | | US | 6423935 B1 | 23-07-2002 |
| | | | WO | 0161619 A1 | 23-08-2001 |
| DE 19518177 | A1 | 21-11-1996 | DE | 19518177 A1 | 21-11-1996 |
| | | | WO | 9637021 A1 | 21-11-1996 |

EPO FORM P0459

For more details about this annex : see Official Journal of the European Patent Office, No. 12/82